Europäisches Patentamt

European Patent Office

Office européen des brevets

(11) Veröffentlichungsnummer: **0 326 824 B1**

(12) **EUROPÄISCHE PATENTSCHRIFT**

(45) Veröffentlichungstag der Patentschrift: **06.04.94**

(21) Anmeldenummer: **89100449.1**

(22) Anmeldetag: **12.01.89**

(51) Int. Cl.5: **H01J 37/08**, H01J 27/18, H05H 1/46, C23C 14/00

(54) Teilchenquelle für eine reaktive Ionenstrahlätz- oder Plasmadepositionsanlage.

(30) Priorität: **05.02.88 DE 3803355**

(43) Veröffentlichungstag der Anmeldung:
**09.08.89 Patentblatt 89/32**

(45) Bekanntmachung des Hinweises auf die
Patenterteilung:
**06.04.94 Patentblatt 94/14**

(84) Benannte Vertragsstaaten:
**AT CH DE FR GB IT LI NL SE**

(56) Entgegenhaltungen:
**EP-A- 0 028 303**
**EP-A- 0 209 469**
**DD-A- 252 916**
**US-A- 4 610 770**
**US-A- 4 611 121**

**PATENT ABSTRACTS OF JAPAN, unexamined applications, E field, Band 10, Nr. 104, 19. April 1986 THE PATENT OFFICE JAPANESE GOVERNMENT Seite 92 E 397**

(73) Patentinhaber: **LEYBOLD AKTIENGESELLSCHAFT**
**Wilhelm-Rohn-Strasse 25,**
**Postfach 1555**
**D-63450 Hanau(DE)**

(72) Erfinder: **Katzschner, Werner, Dipl.-Ing.**
**Am Wingert 18**
**D-8752 Kleinkahl-Grosslaudenbach(DE)**
Erfinder: **Eichholz, Stefan, Dipl.-Ing.**
**Tröndelweg 19**
**D-2300 Kiel 14(DE)**
Erfinder: **Geisler, Michael, Dr. Dipl.-Ing.**
**Chatilloner Strasse 29**
**D-6480 Wächtersbach(DE)**
Erfinder: **Jung, Michael**
**Richard-Wagner-Strasse 5**
**D-8756 Kahl(DE)**

(74) Vertreter: **Schickedanz, Willi, Dipl.-Ing.**
**Langener Strasse 68**
**D-63073 Offenbach (DE)**

**PATENT ABSTRACTS OF JAPAN, unexami-ned applications, E Field, Band 11, Nr. 280, 10. September 1987 THE PATENT OFFICE JA-PANESE GOVERNMENT Seite 92 E 397**

**Plasmaphysik für Physiker, L.A. Artsimo-witsch et al., Seite 166; G.B. Teubner, Stutt-gart 1983**

**Beschreibung**

Die Erfindung betrifft eine Teilchenquelle, insbesondere für eine reaktive Ionenstrahlätz- oder Plasmadepositionsanlage, mit einem Behälter aus einem nicht ferromagnetischen und nichtleitenden Material für ein Gas oder Gasgemisch oder Plasma, der einen oberen Abschluß und einen seitlichen Abschluß aufweist und der gegenüber dem oberen Abschluß eine Öffnung besitzt, aus der gasförmige Teilchen aus dem Behälter austreten können; einer Zuführung für ein Gas oder ein Gasgemisch in den Behälter; einer Vorrichtung für die Zuführung elektromagnetischer Wellen, vorzugsweise von Mikrowellen, die an den oberen Abschluß des Behälters anschließt; wenigstens einem Magnetfelderzeuger, der außerhalb des Behälters angeordnet ist und der wenigstens einen Nordpol und einen Südpol enthält, wobei Nord- und Südpol derart auf den Behälter gerichtet sind, daß sich ein gekrümmtes Magnetfeld zwischen Nord- und Südpol ausbildet, das in das Innere des Behälters hineinragt.

Es ist bereits ein Verfahren zum Ätzen oder chemischen Behandeln von Oberflächen mittels eines Mikrowellen- oder UHF-Plasmas bekannt, bei dem ein dünnes und scheibenförmiges Plasma erzeugt wird (US-PS 4 507 588, US-PS 4 585 668, US-PS 4 630 566, US-PS 4 691 662). Der Durchmesser einer Plasmascheibe ist hierbei relativ groß und beträgt etwa 50 cm. Die Vorrichtung, mit welcher das bekannte Verfahren durchgeführt wird, kann ein statisches Magnetfeld aufweisen, das die Plasmaquelle umgibt und welches dazu dient, eine Elektronen-Zyklotron-Resonanz zu erzeugen. Nachteilig ist bei dieser Vorrichtung, daß sie eine bewegliche Metallplatte besitzt, die zu der Plasmascheibe hin- oder von dieser wegbewegt wird, um bestimmte Resonanzbedingungen herzustellen.

Es ist ferner eine Mikrowellen-Plasmaquelle bekannt, die eine Vakuumkammer besitzt, welche als Entladeraum dient und bei der die Mikrowellenenergie in diesen Entladeraum eingespeist wird (US-PS 4 433 228). Im Ausbreitungsweg der Mikrowelle, der zum Entladeraum führt, ist ein Permanentmagnet angeordnet, der ein Magnetfeld in dem Entladeraum erzeugt. Dieses Magnetfeld dient zur Führung des durch die Mikrowelle erzeugten Plasmas, d. h. im wesentlichen zur Führung der Plasmaelektronen entlang der B-Feldlinien. Hierdurch soll das Plasma so dicht wie möglich an das Substrat herangeführt werden, was bedeutet, daß die Magnetfeldlinien zumindest teilweise das Substrat durchdringen. Eine Elektronen-Zyklotron-Resonanz wird durch das Magnetfeld des Permanentmagneten nicht erzeugt.

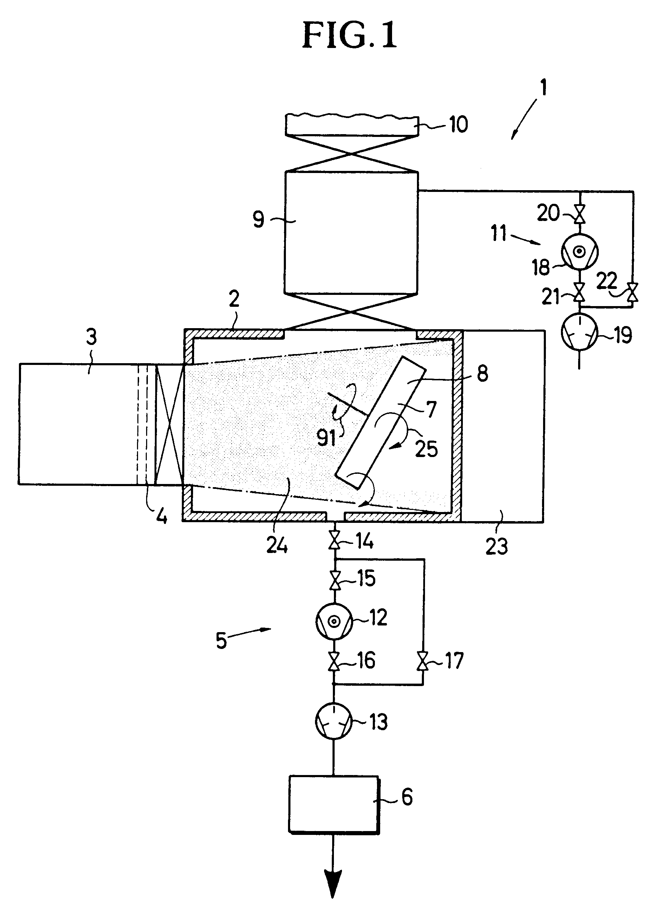

Weiterhin ist eine Vorrichtung bekannt, mit der ein Plasma mittels einer Hochfrequenzwelle erzeugt wird, die in eine Wellenführung eingegeben wird, in der sich ein Glasrohr befindet, in dem Plasma erzeugt wird (DE-OS 31 44 016; Kimura, Murakami, Miyake, Warabisako, Sunami und Tokuyama: "Low Temperature Oxidation of Silicon in a Microwave-Discharged Oxygen Plasma", J. Electrochem. Soc., Solid-State Science and Technology, Vol. 132, No. 6, 1985, S. 1460 - 1466, Fig. 1). Um das Plasma-Erzeugungsrohr ist hierbei eine Spule vorgesehen, die ein Magnetfeld längs der Achse des Glasrohrs erzeugt. Mit einer Kreisfrequenz $\omega$ des Hochfrequenzfeldes und mit einer magnetischen Flußdichte B ergibt sich die Zyklotron-Resonanzfrequenz $\omega = e \cdot B/m \cdot c$, bei der die Energie der Hochfrequenzwelle den Elektronen kontinuierlich zugeführt wird. Nachteilig ist indessen bei dieser Vorrichtung, daß keine homogene Plasmaverteilung erzielbar ist. Entsprechendes gilt auch für andere bekannte Verfahren (DE-PS 26 32 194, DE-PS 31 17 252, DE-OS 33 22 680, US-PS 4 492 620, US-PS 4 585 541).

Ferner ist eine Vorrichtung bekannt, mit der ein Film mittels eines Plasmas von niedriger Temperatur auf einem Substrat aufgetragen werden kann (EP-A2 0 209 109). Diese Vorrichtung weist eine erste Kammer auf, in der das Niedertemperatur-Plasma erzeugt wird, sowie eine zweite Kammer, in der sich das zu beschichtende Substrat befindet. Mit Hilfe einer Gitterelektrode wird das Plasma aus der ersten Kammer in die zweite Kammer gezogen, so daß sich ein Film aktivierten Gases auf der Oberfläche des Substrats niederschlägt. Um die erste Kammer herum ist ein Elektromagnet gelegt, der eine Elektronen-Zyklotron-Resonanz im Plasma erzeugt.

Nachteilig ist bei dieser bekannten Vorrichtung, daß zur Einkopplung des elektromagnetischen Feldes ein Hohlraumresonator eingesetzt wird und daß zur Erzeugung des für die Elektronen-Zyklotron-Resonanzbedingungen notwendigen magnetischen Feldes Elektromagnete verwendet werden., die die Plasmakammer und den Hohlraumresonator umschließen. Hierdurch lassen sich Form und Größe der Plasmakammer nicht beliebig wählen, sondern unterliegen Beschränkungen. Eine Vergrößerung des Resonators bzw. der Plasmakammer über einen Durchmesser von d $\geq$ 30 cm erfordert große Magnetspulen zur Erzeugung des notwendigen magnetischen Feldes. Solche Spulen lassen sich nur mit sehr großem Aufwand realisieren. Die sich aufgrund der Spulenanordnung ergebende Verteilung des magnetischen Feldes ist für die Erzeugung eines homogenen Plasmas nicht optimal. Weiterhin wirken sich Größe und Form des Resonators stark auf die Effizienz der Plasmaerregung aus, da in Abhängigkeit von der Resonatorgeometrie auch die Anzahl der ausbreitungsfähigen Moden des elektromagnetischen Mikrowellenfeldes steigt, die nicht zur Plasmaanregung beitragen. Mit der bekannten Vorrichtung ist es insbesondere nicht möglich, räumlich ausgedehnte Plasmen hoher Effizienz als Quelle für Ionenstrahlen mit beliebiger Querschnittsfläche, hoher Ionenstromdichte und hoher Strahlenhomogenität bei niedrigen Extraktionsenergien zu realisieren.

Weiterhin ist auch noch eine Ionenquelle bekannt, in der durch das Zusammenwirken von Mikrowellen und Magnetfeldern Elektronen-Zyklotron-Resonanzbedingungen geschaffen werden können (US-PS 3 778 656 = DE-OS 22 37 252). Diese Ionenquelle weist eine Ionen-Absaugeinrichtung mit einer Ausdehnungsschale auf, die eine Öffnung besitzt, die mit dem Mikrowellen-Anregungsraum in Verbindung steht. In der Nähe der Öffnung der Ausdehnungsschale ist die Plasmadichte am größten und an einer Absaugelektrode gleich Null. Auch mit dieser bekannten Ionenquelle lassen sich keine homogenen Plasmaverteilungen erreichen.

Bei einer bekannten Mikrowellen-Breitstrahl-Ionenquelle zur Erzeugung eines großflächigen Ionenstrahls sind ein Hohlraumresonator, eine Magnetspule und ein Extraktionssystem vorgesehen (DD-248 904-A1). Der zylindrische Hohlraumresonator hat hierbei einen Entladeraum mit der Höhe h, die sich zum Durchmesser d wie h/d = 0,7 verhält. Dieser Entladeraum ist von einer kreisringförmigen Magnetspule umschlossen, deren Höhe der Höhe des Hohlraumresonators entspricht. Um mit Hilfe des Magnetfeldes dieser Magnetspule die ECR-Bedingung erfüllen zu können, müssen sehr hohe Ströme durch die Spule fließen. Außerdem ist für die Einkopplung der elektromagnetischen Wellen ein Koppelloch vorgesehen, dessen Durchmesser etwa nur halb so groß ist wie der Durchmesser des Hohlraumresonators, in dem sich das Plasma befindet. Zu diesem Koppelloch werden die Mikrowellen über einen $E_{01}$-Rundhohlleiter, dessen Durchmesser dem Durchmesser des Koppellochs entspricht, geführt.

Außerdem ist auch noch eine Ionenquelle bekannt, die einen Vakuumbehälter aufweist, der sich in dieselbe Richtung wie eine ankommende Mikrowelle erstreckt (JP-62-80950-A1). Um den Vakuumbehälter herum sind hierbei Dauermagnete vorgesehen, wobei der Nordpol des einen Dauermagnets mit dem Südpol des benachbarten Dauermagnets ein bogenförmiges Magnetfeld erzeugt, das in den Vakuumbehälter hineinragt. Mit der hohen Feldstärke, die moderne Dauermagnete erzeugen können, ist es leicht möglich, die ECR-Bedingung zu erfüllen. Auch bei dieser Ionenquelle erfolgt die Einkopplung der elektromagnetischen Wellen mittels eines Rundhohlleiters, dessen Durchmesser nur dem halben Durchmesser des Vakuumgefäßes entspricht. Durch den abrupten Übergang vom Rundhohlleiter zum Vakuumgefäß wird das Strahlungsfeld stark beeinflußt, was zu einer Reflexion der speisenden Wellen und zur Anregung anderer Wellentypen in der Apertur führt.

Des weiteren offenbart US-A-4 611 121 eine Teilchenquelle, bei der Mikrowellen über einen Trichterstrahler in die Plasmakammer eingespeist werden. Mittels eines außerhalb der Plasmakammer angeordneten zylinderförmigen Permanentmagneten mit Zusatzjoch wird ein rotationssymmetrisches Magnetfeld, erzeugt, das im Zentrum der Plasmakammer die ECR-Bedingung erfüllt. Der Teilchenstrahl wird mit Hilfe von Extraktionselektroden in eine Bearbeitungskammer geführt.

Aus EP-A-0 209 469 ist bekannt, daß sich magnetische Multipolfelder zur Erzeugung eines großvolumigen, homogenen Plasmas hoher Dichte eignen, wenn sie im Bereich der Seitenwand der Plasmakammer liegen und auch die Mikrowellenenergie dort eingespeist wird.

Weiterhin ist eine Mikrowellen-Plasmaionenquelle zur Erzeugung eines großflächigen Ionenstrahls bekannt, die eine Anordnung zur Einkopplung von Mikrowellen in ein Niederdruckplasma, einen Entladungsraum, ein Extraktionssystem und eine Magnetspule aufweist (DD-A-252 916). Die Einkopplung der Mikrowellen erfolgt hierbei in einem zylindrischen, dosenförmigen Entladungsraum über eine obere Deckenplatte in der Nähe des äußeren Rands über einen Koppelschlitz, über Einkoppelstifte oder über induktive Koppelschleifen.

Aus US-A-4 610 770 ist eine Vorrichtung bekannt, bei der Mikrowellen über einen Trichterstrahler in eine Plasmakammer eingespeist werden und in Verbindung mit einem speziellen Magnetfeld, einem sogenannten magnetischen Spiegel, ein Plasma hoher Teilchendichte erzeugen, welches zur Probenbearbeitung durch eine Öffnung in eine Prozeßkammer geführt wird.

Der Erfindung liegt die Aufgabe zugrunde, einen Strahl mit hoher Teilchenstromdichte aus geladenen und/oder neutralen Teilchen zu erzeugen, der großflächig ist und der einen beliebigen Querschnitt aufweisen kann.

Diese Aufgabe wird gemäß den Merkmalen der Patentansprüche 1 und 2 gelöst.

Der mit der Erfindung erzielte Vorteil besteht insbesondere darin, daß eine sehr gleichmäßige und großflächige Strahlung von Teilchen ermöglicht wird, wobei die geladenen Teilchen im wesentlichen durch Steuergitter abgesogen werden. Der verwendete Hohlleiterstrahler, der bei einem Ausführungsbeispiel am offenen Ende trichterförmig aufgeweitet ist, wird Trichterstrahler oder auch Hornstrahler genannt. Entsprechend dem Querschnitt des Hohlleiters hat die Aufweitung rechteckförmigen, quadratischen oder runden Querschnitt. Je nachdem, ob die Aufweitung in Richtung des elektrischen Feldvektors E oder des magnetischen Feldvektors H erfolgt, bezeichnet man den Hornstrahler als E-Sektorhorn bzw. H-Sektorhorn. In der trichterförmigen Erweiterung des Hornstrahlers wird ein dem eingespeisten Wellentyp ähnlicher Wellentyp bis zur Aperturöffnung weitergeführt, während wegen der Diskontinuität am Hornhals angeregte höhere Wellentypen - bei nicht zu großem Hornöffnungswinkel - stark (reaktiv) gedämpft werden und zur Strahlung kaum beitragen. Neben dem E-Sektorhorn und dem H-Sektorhorn sind noch das Pyramidenhorn und das Kegelhorn bekannt. Das Pyramidenhorn kann bezüglich seiner Strahlung als Kombination von E- und H-Sektorhorn aufgefaßt werden. Pyramiden- und Kegelhörner mit $\delta/\lambda > 0{,}5$ ($\delta$ = Öffnungswinkel) haben besondere Strahlungseigenschaften; es handelt sich um quasioptische Hörner. Insbesondere ändert sich die Hauptkeule nur wenig mit der Frequenz. Hornstrahler dienen also unter anderem dazu, Kugelwellen in ebene Wellen zu verwandeln, wie es aus der Optik im Hinblick auf den Parabolspiegel bekannt ist.

Ein besonderer Vorteil der Erfindung besteht darin, daß durch die Mikrowelleneinstrahlung über den Hornstrahler diese Energie kontinuierlich in das Plasma gelangt, so daß hauptsächlich Wirkleistung übertragen wird. Bei dem Einsatz von Hohlraumresonatoren, wie er im Stand der Technik weitgehend üblich ist, tritt ein sehr hoher Blindleistungsanteil auf.

Mit der Erfindung wird eine Teilchenquelle geschaffen, mit der es möglich ist, einen Plasmastrahl, einen Ionenstrahl, einen Elektronenstrahl oder einen Neutralteilchenstrahl zu erzeugen, der zur Strukturierung von Festkörperoberflächen, zur Modifikation der Struktureigenschaften von Oberflächen, wie Amorphisieren, Verdichten oder Implantieren, sowie zum Deponieren eingesetzt werden kann. Das Deponieren ist dabei aus dem Strahl heraus, durch Abscheiden aus einer Gasphase oder durch Absputtern von einem Festkörper möglich. Der erfindungsgemäß hergestellte Strahl ist sehr großflächig und hat eine beliebige Form. Vorzugsweise ist er jedoch rund, rechteckig oder oval. Ein runder Strahl hat beispielsweise einen nutzbaren Durchmesser von mehr als 200 Millimeter. Die Teilchenstromdichte, bezogen auf einfach positiv geladene Ionen, ist größer als 10 mA/m². Die Teilchenenergie ist variabel im Bereich > 10 eV - < 10 KeV. Mit dem Strahl wird eine Homogenität der Teilchenstromdichte von > 95 % erreicht, d. h. die Teilchendichtevariation über dem Strahlquerschnitt ist kleiner als 5 %. Die erfindungsgemäße Teilchenquelle arbeitet bei einem hohen Ionisationsgrad im Druckbereich von: $P \leq 10^{-2}$ Pa bis $P \geq 10^3$ Pa (= von $P \leq 10^{-4}$ mbar bis $P \geq 10$ mbar). Es ist ein Betrieb mit inerten und reaktiven Substanzen möglich, z. B. reaktive Gase, Edelgase und Gasgemische. Der hohe absolute Ionisationsgrad des Plasmas wird insbesondere durch die Kombination der torusförmigen Magnetfelder mit der Mikrowelleneinkopplung über Hornstrahler erreicht. Außerdem ergibt sich durch die Verwendung von einem oder zwei ringförmigen Magnetsätzen und gegebenenfalls durch den Einsatz eines zusätzlichen überlagernden Magnetfelds eine homogene Plasmaverteilung. Die Verwendung besonderer Extraktionsoptiken sowie eines Plasmabehälters aus Quarz minimiert die Plasmaverunreinigungen. Da die Permanentmagnete außerhalb des Plasmas angeordnet sind, treten innerhalb des Plasmas keine Kontaminationen auf.

Ein Ausführungsbeispiel der Erfindung zeichnet sich durch die Verwendung von Permanentmagneten und durch die besondere Form des durch die Magnetanordnung hervorgerufenen Magnetfelds aus. Für den Fall der rotationssymmetrischen Quellen ergeben sich torusförmige bzw. doppel-torusförmige Magnetfelder, was zu besonders verlustarmen Plasmen führt, die sich durch hohe Ionisationsdichte, hohe Reaktivität und somit hohe Produktivität auszeichnen. Eine solche Anordnung liefert die Voraussetzung für eine hohe Teilchenstromdichte im extrahierten Teilchenstrahl. Der rotationssymmetrische Aufbau und das außenliegende torusförmige Magnetfeld bewirken eine sehr gute radiale Gleichmäßigkeit der Plasmaverteilung und damit eine extrem hohe Strahlhomogenität. Die Verwendung eines zweiten, zentralen Magnetfelds in der rotationssymmetrischen Anordnung bringt eine weitere Verbesserung der radialen Gleichmäßigkeit mit sich.

Inhomogene, nicht toroidförmige Magnetfelder erzeugen im allgemeinen im Plasma Ladungsträgerdriftbewegungen, die für positive Ionen und Elektronen entgegengesetzt sind. Durch die hiermit bewirkte Ladungstrennung werden Plasmainstabilitäten erzeugt, die die Plasmaverluste erhöhen und die mittlere Elektronendichte erniedrigen. Toroidförmige Magnetfelder, wie das in der Erfindung verwendete haben den Vorteil, daß die Ladungsträgerdriftbewegungen nicht zu einer Ladungstrennung führen, somit also die oben erwähnten Plasmainstabilitäten nicht auftreten können. Die Elektronendichte ist in solchen torusmagnetfeldgeführten Plasmen besonders hoch. Infolgedessen ist die chemische Reaktivität erhöht, was einen Zweck der Erfindung darstellt.

Mit der erfindungsgemäßen Plasmaanregungsart lassen sich Teilchenstrahlen mit sehr geringer Energieunschärfe erzeugen. Durch Schrägstellen der Magnetpole lassen sich das Extraktionsverhalten und die Strahleigenschaften zusätzlich positiv beeinflussen. Vorzugsweise sind die Magnetpole in einem Winkel von 90°, bezogen auf die Extraktionsrichtung, angeordnet. Ein weiterer Vorteil besteht darin, daß die erfindungsgemäße Quelle nicht auf eine zylindersymmetrische Anordnung beschränkt ist, sondern daß sich beliebige Quellenformen und damit auch beliebige Strahlformen ohne Verschlechterung der Quelleneffizienz realisieren lassen. Die Überlagerung eines zusätzlichen magnetischen Feldes gestattet es, des Betriebsverhalten der Quelle zu beeinflussen, etwa durch Minimierung der Wandverluste im Plasmaraum oder durch Verschieben der Zone der Elektronen-Zyklotron-Resonanz im Plasmaraum, was die Strahlhomogenität beeinflußt.

Die erfindungsgemäße Teilchenquelle ist insbesondere für den Einsatz in der Mikrostrukturtechnologie geeignet, weil sie im Gegensatz zum bekannten Plasma- und Ionenätzen den ständig steigenden Anforderungen gerecht wird.

Ausführungsbeispiele der Erfindung sind in der Zeichnung dargestellt und werden im folgenden näher beschrieben. Es zeigen:

Fig. 1      eine schematische Darstellung einer reaktiven Ionenstrahlätz- oder Plasmadepositionsanlage;

Fig. 2      eine erste Ausführungsform einer Elektronen-Zyklotron-Resonanz-Mikrowellenionenquelle;

Fig. 3      eine perspektivische Darstellung von ringförmig angeordneten Dauermagneten, die in der Ionenquelle gemäß Fig. 1 verwendet werden;

Fig. 4      eine zweite Ausführungsform einer Elektronen-Zyklotron-Resonanz-Mikrowellenionenquelle;

Fig. 5      eine dritte Ausführungsform einer Elektronen-Zyklotron-Resonanz-Mikrowellenionenquelle;

Fig. 6      eine vierte Ausführungsform einer Elektronen-Zyklotron-Resonanz-Mikrowellenionenquelle;

Fig. 7a bis 7d      verschiedene elektrische Beschaltungen der in den Fig. 2, 4, 5, 6 dargestellten Mikrowellenionenquellen;

Fig. 8      eine erste Vorrichtung zur Einspeisung der Mikrowellenenergie in eine Ionenquelle;

Fig. 9      eine zweite Vorrichtung zur Einspeisung der Mikrowellenenergie in eine Ionenquelle;

Fig. 10      eine Prinzipdarstellung von drei Extraktionsgittern, einem Plasmaraum und einem Probentisch;

Fig. 10a      den Potentialverlauf über drei Extraktionsgitter bei der Extraktion von positiven Ionen;

Fig. 10b      den Potentialverlauf über drei Extraktionsgitter bei der Extraktion von Elektronen und negativen Ionen;

Fig. 10c      den Potentialverlauf über drei Extraktionsgitter bei der Extraktion neutraler Teilchen.

In der Fig. 1 ist eine Ionenstrahlätz- bzw. Plasmadepositionsanlage 1 im Prinzip dargestellt, die eine Reaktionskammer 2, eine Ionenquelle 3 mit einer Extraktionseinrichtung 4, ein Pumpsystem 5 für aggressive Stoffe, eine Abgasentgiftungsvorrichtung 6, eine Probenpositioniereinrichtung 7 mit Fixiermechanismus 8, eine Vakuumschleuse 9 mit einer Probentransfereinrichtung, einen Anschluß 10 für eine Kassettenstation sowie ein Pumpsystem 11 für die Vakuumschleuse 9 aufweist.

Das Pumpsystem 5 für die aggressiven Stoffe enthält zwei Pumpen 12, 13 sowie vier Ventile 14 bis 17, während das Pumpsystem 11 für die Vakuumschleuse mit zwei Pumpen 18, 19 und drei Ventilen 20, 21, 22 versehen ist. Derartige Pumpsysteme sind bekannt und werden deshalb nicht näher beschrieben.

Im Anschluß an die Reaktionskammer 2 ist noch eine Einrichtung 23 für die Durchführung von Analysen sowie für die Prozeßsteuerung vorgesehen. Der Teilchenstrahl 24, der von der Ionenquelle 3 ausgehend in die Reaktionskammer 2 gelangt, ist durch zahlreiche Punkte angedeutet. Pfeile 25,91 deuten an, daß die Probenpositioniereinrichtung 7 zur Einstellung beliebiger Beschußmittel der Probe um eine Achse drehbar ist und eine um die Mittelachse rotierbare Probenplattform besitzt.

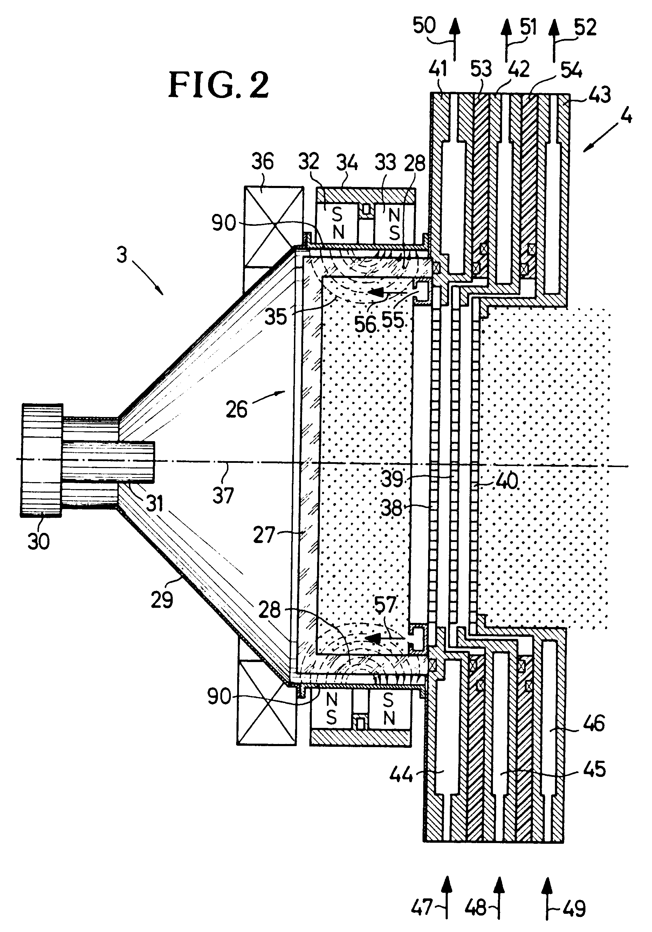

Der eigentliche Erfindungsgegenstand betrifft die in der Fig. 1 nur schematisch dargestellte Teilchenquelle 3 mit der Extraktionseinrichtung 4. In der Fig. 2 sind nähere Einzelheiten dieser Teilchenquelle dargestellt.

Diese Teilchenquelle weist einen Behälter 26 aus Quarz auf, der einen rundflachen oder rundgewölbten Boden 27 und eine zylindrische Seitenwand 28 besitzt. An den Boden 27 des Behälters 26 schließt ein kegelförmiger Hornstrahler 29 an, der an einen den Behälter 26 umgebenden Hohlkörper 90 aus leitendem, nicht ferromagnetischem Material angeflanscht ist. In den Hornstrahler 29 wird eine elektromagnetische Welle über ein Koppelglied 30 und einen Koppelstift 31 eingespeist.

Um die zylindrische Seitenwand 28 sind zwei Dauermagnete 32, 33 gelegt, wobei der Nordpol des einen Dauermagneten 32 auf den Behälter 26 gerichtet ist, während der Nordpol des anderen Dauermagneten 33 von diesem Behälter 26 wegweist. Diese Dauermagnete 32, 33, die extrem starke Felder besitzen und beispielsweise vom Typ Vacumax 140 oder Vacudyn sind, sind von einem außenliegenden Eisenjoch 34 umgeben, um ein torusförmiges Magnetfeld 35 im Innern des als Reaktorgefäß dienenden Behälters zu erzeugen, das eine magnetische Induktion liefert, die bei einer vorgegebenen Anregungsfrequenz des Mikrowellenfeldes die Elektronen-Zyklotron-Resonanzbedingungen erfüllt. Statt zweier Dauermagnete ist es auch möglich, einen Hufeisenmagneten oder Elektromagnete einzusetzen.

Innerhalb des Behälters 26 wird unter Ausnutzung dieser Elektronen-Zyklotron-Resonanz (ECR) ein Plasma hoher Ionisationsdichte erzeugt. Die bei vorgegebener Anregungsfrequenz von z. B. 2,45 GHz zur Erfüllung der ECR-Bedingungen notwendige Induktion von 875 Gauss ergibt sich durch das torusförmige Magnetfeld 35. Wenn im folgenden von "Mikrowellen" und von "ECR-Bedingungen" die Rede ist, so sind hiermit alle Frequenzbereiche elektromagnetischer Strahlung eingeschlossen, mit denen ECR-Bedingungen erfüllbar sind, und solange anregungsfähige Moden des elektromagnetischen Feldes ausbreitungsfähig sind. Es muß auch nicht stets die Resonanzbedingung erfüllt sein, sondern es genügt, wenn eine nicht unwesentliche Verstärkung auftritt.

Neben den beiden Dauermagneten 32, 33 ist noch ein zusätzlicher Elektromagnet 36 vorgesehen, der um den Hornstrahler 29 gelegt ist, und zwar direkt an den Magneten 32 anschließend. Mit Hilfe dieses Elektromagneten wird ein magnetisches Feld erzeugt, dessen Feldlinien im wesentlichen parallel zur Mittelachse 37 des Hornstrahlers 29 verlaufen und das die Plasmaverteilung beeinflußt.

Am Ausgang des Behälters 26 befindet sich die Extraktionseinrichtung 4. Diese weist drei Extraktionsgitter 38, 39, 40 auf, die auf unterschiedlichen Potentialen liegen. Jedes dieser Extraktionsgitter 38, 39, 40 ist an seinem Randbereich mit einem eigenen Träger 41, 42, 43 verbunden, der einen Hohlraum 44, 45, 46 aufweist. Dieser Hohlraum 44, 45, 46 dient zur Aufnahme eines Kühlmittels, z. B. von Wasser. Das Wasser wird durch Öffnungen in die Träger 41 bis 43 eingegeben - was durch die Pfeile 47, 48, 49 angedeutet ist - und durch Ausflußöffnungen aus den Trägern 41 bis 43 herausgeführt, was durch die Pfeile 50, 51, 52 angedeutet ist. Zwischen zwei benachbarten Trägern 41, 42 bzw. 42, 43 ist jeweils eine elektrische Isolationsschicht 53, 54 vorgesehen.

Der Träger 41, der mit demjenigen Gitter 38 in Verbindung steht, das dem Behälter 26 direkt gegenüberliegt, weist einen Gaseinlaß 55 auf, der integraler Bestandteil dieses Trägers 41 ist. Die Zuführung des Gases in diesen Gaseinlaß erfolgt durch mindestens eine Bohrung im Träger 41. Die Einströmung des Gases ist durch die Pfeile 56, 57 angedeutet.

Die Erzeugung und der Transport von Ionen mittels der in der Fig. 2 dargestellten Vorrichtung geschieht auf folgende Weise.

Das Gas, welches durch den Gaseinlaß 55 in den Behälter 26 einströmt, wird durch die elektromagnetische Welle ionisiert, die vom Hornstrahler 29 abgestrahlt wird. Aufgrund der magnetischen Feldverteilung, die durch die Dauermagnete 32, 33 hervorgerufen wird, bildet sich innerhalb des Quarzbehälters 26 eine "Rennbahn" für Elektronen und Ionen aus, wie sie auch von Magnetron-Sputterkathoden her bekannt ist. Dadurch ist es möglich, den Ionisationsgrad, der allein aufgrund der Mikrowelleneinstrahlung noch nicht sehr groß ist, wesentlich zu erhöhen. Der Vorteil des toroidförmigen Magnetfeldes gegenüber anderen Magnetfeldern besteht beim Elektronen-Zyklotron-Resonanzverfahren darin, daß im Randbereich des Behälters 26, d. h. im Wirkungsbereich des elektromagnetischen Wechselfeldes, ein magnetisches Feld geschaffen wird, das die ECR-Bedingungen erfüllt. Dadurch entsteht eine Zone mit sehr hoher Ionisationseffizienz, die den für die Teilchenextraktion relevanten Plasmabereich umschließt und in diesen Plasmabereich die zu extrahierenden Plasmabestandteile liefert. Das überlagerte Magnetfeld des Elektromagneten 36 bewirkt, je nach Richtung des erzeugten Magnetfeldes, eine radiale Kontraktion bzw. eine radiale Expansion des ECR-Anregungsbereichs und dient der Steuerung der Plasmadichteverteilung im Behälter 26.

Das im Behälter 26 befindliche Plasma, das in der Fig. 2 durch Punkte angedeutet ist, kann nur mit Hilfe besonderer Steuerungsverfahren als Ionenquelle, Elektronenquelle oder als Quelle für neutrale Teilchen dienen. Wird das Gitter 38 auf positives Potential, das Gitter 39 auf negatives Potential und das Gitter 40 auf Potential Null (Masse) gelegt, so bleiben die negativ geladenen Teilchen (Elektronen, negative Ionen) im Behälter gefangen, während die positiv geladenen Teilchen (positive Ionen) abgesogen werden. Durch diese Beschaltung werden die positiven Teilchen zuerst mit einer hohen Spannung extrahiert (Summe der Spannungen an Gitter 38 und 39) - dadurch wird eine hohe Teilchenstromdichte erreicht - und anschließend durch die Potentialdifferenz zwischen Gitter 39 und Gitter 40 abgebremst (acceleration, deceleration). Mit Hilfe dieser Beschaltung lassen sich hohe Ionenstromdichten bei niedriger Ionenenergie realisieren.

Wird das Gitter 38 auf negatives Potential, das Gitter 39 auf positives Potential und das Gitter 40 auf Nullpotential (Masse) gelegt, so bleiben die positiven Teilchen im Behälter gefangen, während die negativ geladenen Teilchen (Elektronen, negative Ionen) abgesogen werden. Die negativen Teilchen werden wiederum mit einer hohen Spannung (Summe der Spannungen zwischen Gitter 38 und 39) extrahiert, was eine hohe Teilchenstromdichte zur Folge hat, und durch die Potentialdifferenz zwischen Gitter 39 und Gitter 40 abgebremst.

Neutrale Teile können z. B. dadurch erzeugt werden, daß das Gitter 38 auf positivem Potential, das Gitter 39 auf negativem Potential und das Gitter 40 wiederum auf positivem Potential liegt, wobei die Potentiale so hoch gewählt sein müssen, daß die Gitter als Sperre für elektrisch geladene Teilchen gelten und nur neutrale Teilchen durchlassen, die dann allerdings nicht elektrisch beschleunigt werden, sondern nur die Geschwindigkeit der temperaturabhängigen Molekularbewegung haben.

Die Kühlung der Träger 41, 42, 43 mittels Wasser oder einem anderen Medium bewirkt auch eine Kühlung der Gitter 38 bis 40 selbst. Dies hat den Vorteil, daß diese sich nicht durch aufprallende Plasmateilchen übermäßig erwärmen und dadurch zerstört werden.

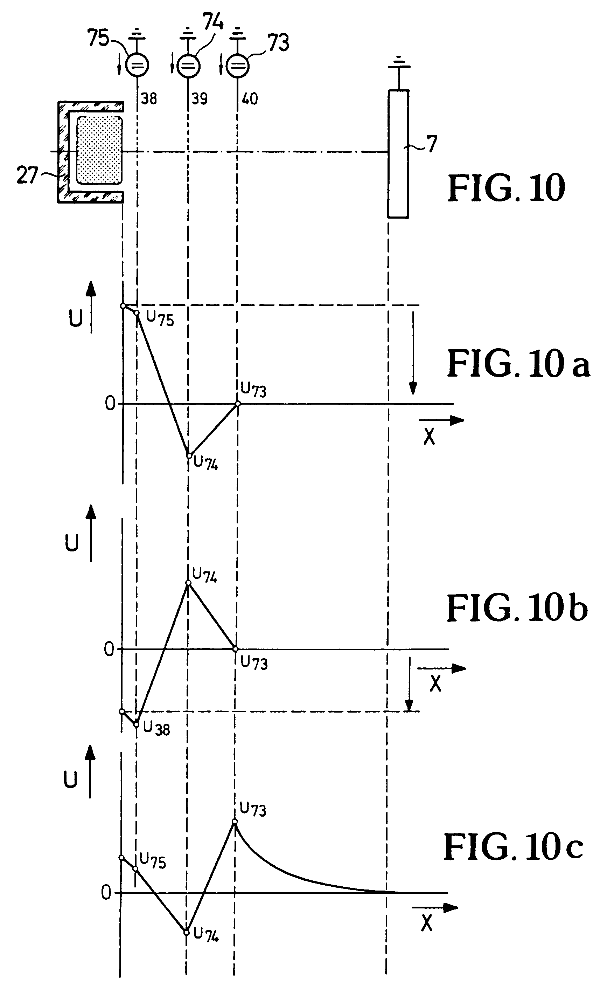

Die Spannungsverläufe, die sich durch die verschiedenen Gitterpotentiale ergeben, sind in den Fig. 10a bis 10c dargestellt und werden dort noch einmal bezüglich ihrer Wirkung beschrieben.

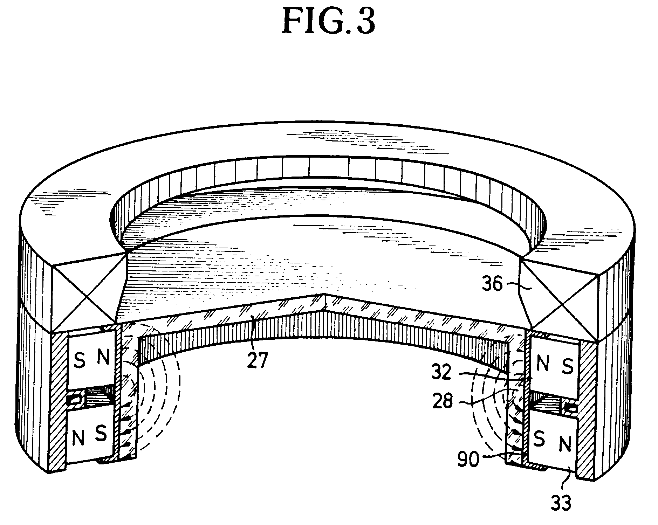

In der Fig. 3 ist eine perspektivische Ansicht des Behälters 26 mit den ihn umgebenden Dauermagneten 32, 33 dargestellt. Man erkennt hierbei deutlich das toroidförmige Magnetfeld für die Erzeugung der Elektronen-Zyklotron-Resonanz.

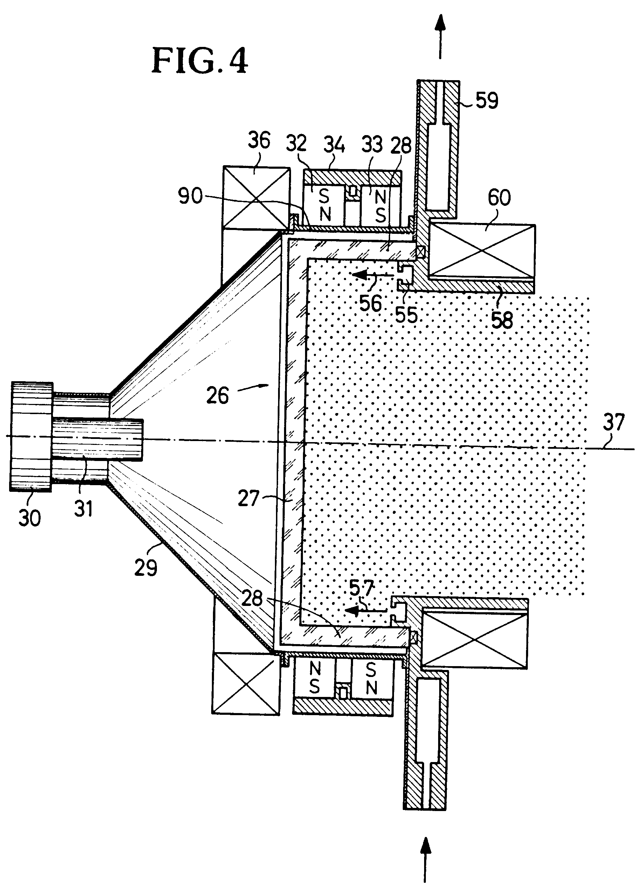

Die Fig. 4 zeigt eine weitere Ausführungsform der Erfindung, bei welcher das Plasma auf dieselbe Weise wie bei der Vorrichtung gemäß Fig. 2 erzeugt wird, aber für die Extraktion der geladenen Teilchen andere Mittel vorgesehen sind. Anstelle von elektrischen Gleich- und/oder Wechselfeldern, die von den Steuergittern 38 bis 40 ausgehen, werden magnetische Felder für die Extraktion herangezogen. Um einen ringförmigen Körper 58, der die Gaszuführung 55 enthält und der mit einer Kühleinrichtung 59 versehen ist, ist ein Elektromagnet 60 gelegt, der ein Magnetfeld erzeugt, dessen mittlere Feldlinien entlang der Achse 37 verlaufen.

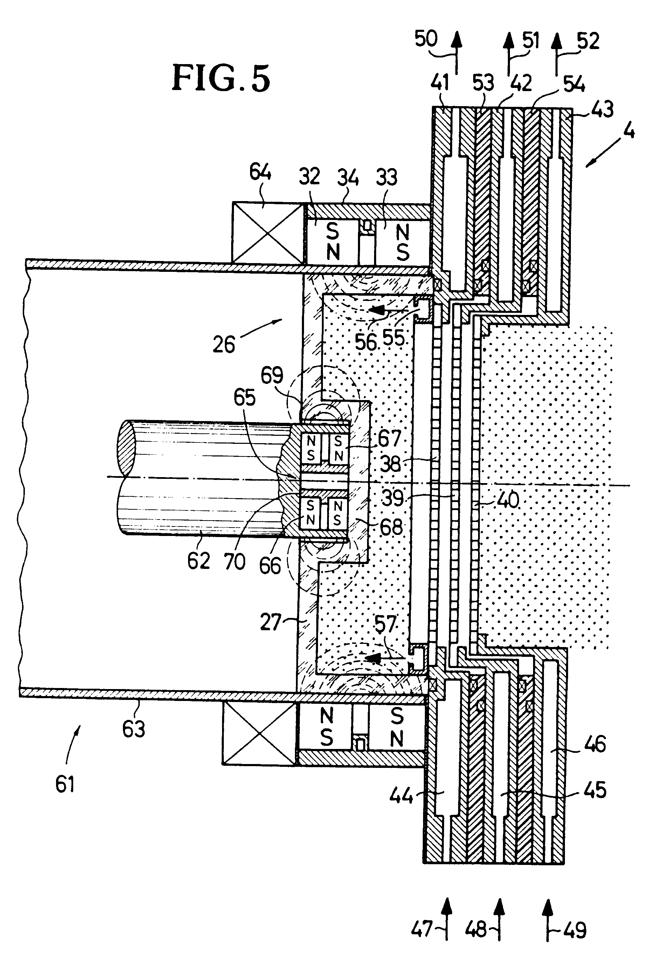

In der Fig. 5 ist eine weitere Ausführungsform der Erfindung dargestellt, bei welcher die Einkopplung der Mikrowellenstrahlung nicht durch einen Hornstrahler, sondern durch einen geeignet dimensionierten koaxialen Wellenleiter 61 erfolgt, der einen Innenleiter 62 und einen Außenleiter 63 aufweist. Eine weitere Besonderheit liegt in der Verwendung von einem ringförmigen Elektromagneten 64, der ähnlich angeordnet ist wie der Elektromagnet 36 der Fig. 2, sowie in der Verwendung eines ringförmigen Magneten 65, der im Endstück des Innenleiters 62 des koaxialen Wellenleiters angeordnet ist. Das Endstück des Innenleiters 62 des koaxialen Wellenleiters 61 ragt mit dem Teil, der den ringförmigen Magneten 65 beinhaltet, in eine Einbuchtung 68 des Bodens 27 des Behälters 26. Die Pole des ringförmigen Magneten 65 befinden sich vollständig in der Einbuchtung 68 und weisen auf das Innere des Behälters 26 und erzeugen im Inneren des Behälters ein zweites torusförmiges Magnetfeld. Zwischen den beiden die Polflächen bildenden Magnetringen besteht eine magnetische Verbindung über ein Eisenjoch 70, das die Form einer zylindrischen Buchse hat.

Die Richtung der Magnetfeldlinien 69 kann mit der Richtung der Magnetfeldlinien 35 übereinstimmen oder diesen entgegengerichtet sein. Durch entsprechenden Einbau der Ringmagnete 66, 67 in die Ausbuchtung 68 ist die Richtung der Magnetfeldlinien 69 wählbar.

Die Verwendung von zwei torusförmigen Magnetfeldern schafft bei geeigneter Wahl der Feldstärken zwei Elektronenrennbahnen und damit zwei ringförmige ECR-Zonen. Hierdurch läßt sich die Dichteverteilung im Plasmaraum und damit die Homogenität des zu extrahierenden Teilchenstrahls beeinflussen. Eine Verstärkung dieses Homogenisierungseffekts ist noch dadurch möglich, daß der Elektromagnet 64 vorgesehen ist, der das Ende des Außenleiters 63 umgibt.

Wie aus der Fig. 5 ersichtlich, sind der Außenleiter 63 und der Innenleiter 62 des Koaxialkabels 61 an die Geometrie des Behälters 26 angepaßt. Der Durchmesser des Außenleiters 63 entspricht im wesentlichen dem Durchmesser des Behälters, während der Durchmesser des Innenleiters 62 im wesentlichen dem Durchmesser der Einbuchtung 68 entspricht.

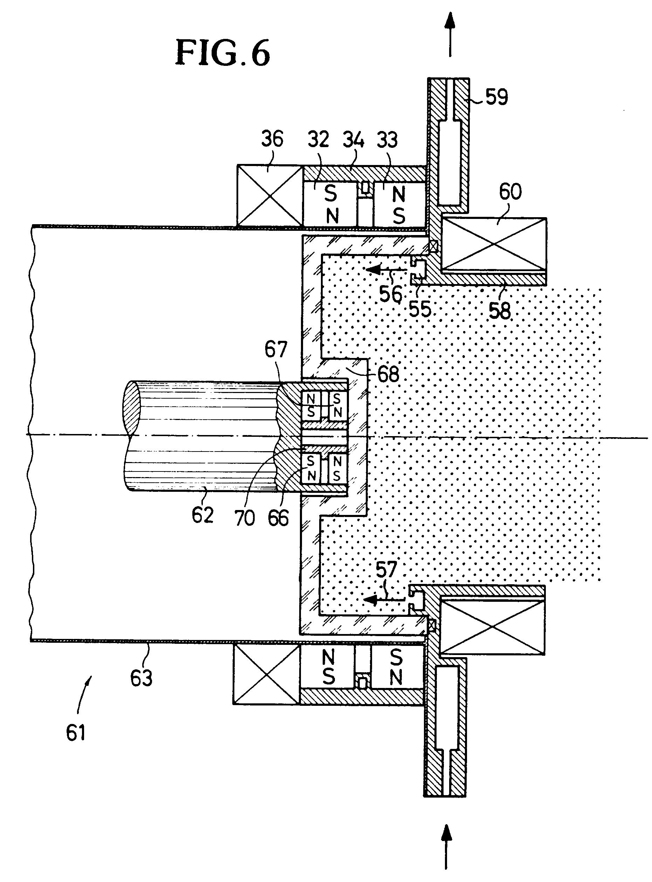

Das in der Fig. 6 dargestellte Ausführungsbeispiel ist eine Mischform der in den Figuren 4 und 5 dargestellten Ausführungsformen. Die Dauermagnete 32, 33, die Elektromagnete 36, 60, die Gaszuführung 55 und die Kühleinrichtung 59 sind entsprechend der Vorrichtung nach Fig. 4 angeordnet, während die Zuführung der Mikrowellenenergie und das zweite ECR-Gebiet entsprechend der Vorrichtung gemäß Fig. 5 angeordnet sind. Im Gegensatz zur Vorrichtung der Fig. 5 wird also bei der Vorrichtung gemäß Fig. 6 ein magnetisches Feld zur Teilchenextraktion verwendet, wobei dieses magnetische Feld durch die Elektromagnete 36 und 60 erzeugt wird.

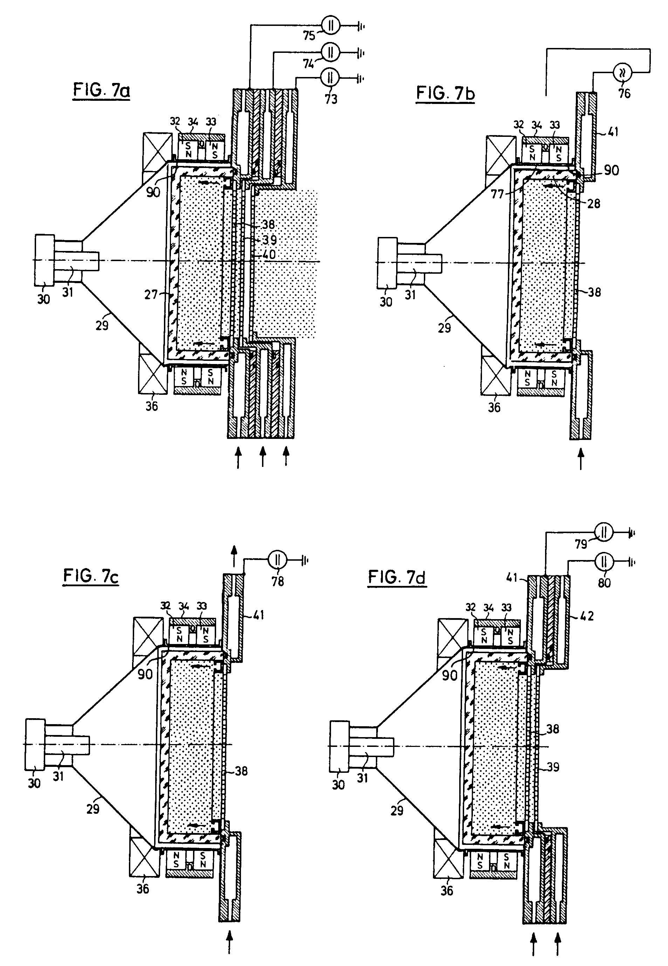

In der Fig. 7a ist die Ionenquelle gemäß Fig. 2 noch einmal dargestellt, wobei jedoch nunmehr die elektrischen Anschlüsse der Gitter dargestellt sind. Man erkennt hierbei, daß die Gitter jeweils auf beliebigen Potentialen liegen. Diese Potentiale sind durch die Spannungsquellen 73, 74, 75 symbolisiert.

Die Fig. 7b zeigt eine Ionenquelle, die nur ein Extraktionsgitter 38 aufweist und bei der die Ionen mittels einer Wechselspannung extrahiert werden.

Das Extraktionsgitter 38 besteht aus leitfähigem Material, das mit einem isolierenden Überzug versehen sein kann. An dem Träger 41 des Gitters 38 liegt der eine Pol einer Wechselspannungsquelle 76, deren anderer Pol mit einem Metallstreifen 77 verbunden ist, der die Seitenwand 28 ringförmig umschließt.

Eine Gleichspannungsextraktion mit nur einem Gleichstrompotential ist in der Fig. 7c dargestellt. Eine Gleichspannungsquelle 78 ist hierbei mit einem Anschluß und dem Träger 41 und damit mit dem Gitter 38 verbunden, während der andere Anschluß der Gleichspannungsquelle an Masse liegt.

Die Fig. 7d zeigt eine Gleichstrom-Zweigitteranordnung, bei welcher die beiden Gitter 38, 39 jeweils an einem bestimmten Potential liegen. Diese Potentiale werden von den Gleichspannungsquellen 79, 80 bereitgestellt.

Alle Gleichspannungsquellen 73, 78, 79, 80 sind sowohl von Null bis zu einem bestimmten Maximalwert regelbar als auch bezüglich der Polarität umschaltbar.

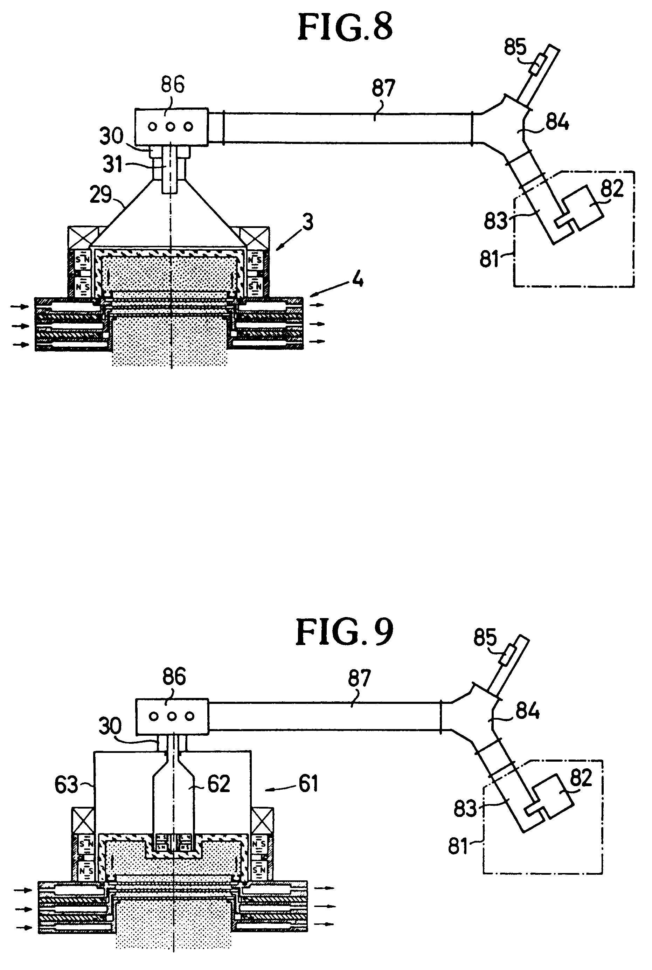

In der Fig. 8 ist dargestellt, wie die Mikrowellenleistung der Plasmakammer zugeführt wird. Hierfür ist ein Mikrowellengenerator 81 vorgesehen, der aus dem eigentlichen Generator 82 und einem Anschlußstück 83 besteht. Dieses Anschlußstück ist mit einem Zirkulator 84 verbunden, an den ein Anpassungswiderstand 85 angeschlossen ist, der als sogenannter Mikrowellensumpf dient. Der Zirkulator 84 ist seinerseits über einen Rechteckhohlleiter 87 an einen Impedanztransformator 86 angeschlossen. Dieser Impedanztransformator 86 ist über ein Koppelglied 30 mit dem Hornstrahler 29 verbunden. Zur potentialmäßigen Trennung kann in das Koppelglied 30 ein Isolator eingeführt werden.

Bei der Anordnung der Fig. 9 werden für die Erzeugung der Mikrowellen dieselben Elemente 81 bis 89 verwendet wie bei der Anordnung gemäß Fig. 8. Die Einspeisung der Mikrowellen erfolgt in diesem Fall jedoch über den koaxialen Wellenleiter 61.

In der Fig. 10 sind die Plasmakammer mit dem Boden 27, drei Spannungsquellen 73, 74, 75, die Gitter 38, 39, 40 sowie der Probentisch 7 im Prinzip dargestellt.

Die Fig. 10a zeigt den Verlauf des Potentialgefälles von der Plasmakammer zum Probentisch 7 für das Absaugen von positiven Ionen. Die effektive Beschleunigungsspannung, die unmittelbar am Ausgang der Plasmakammer 27 ansteht, ist hierbei durch den Schnittpunkt der gestrichelten Linien mit der U-Achse gekennzeichnet. Das Potential, das am Gitter 38 anliegt, ist positiv und etwas geringer als die effektive Beschleunigungsspannung. Hierdurch entsteht ein negatives Spannungsgefälle, das die positiven Ionen anzieht und negative Elektronen abstößt. Am Gitter 39 liegt ein so großes negatives Potential, daß am Ort des Gitters insgesamt negatives Potential ansteht. Dieses negative Potential wird durch das Potential am Gitter 40 am Ort dieses Gitters 40 auf Null gebracht. Durch das negative Spannungsgefälle zwischen den Gittern 38 und 39 werden die positiven Ionen zunächst stark beschleunigt und anschließend aufgrund des positiven Spannungsabfalls zwischen den Gittern 39, 40 wieder etwas abgebremst.

Die effektive Beschleunigungsspannung für das Absaugen von Elektronen und negativen Ionen ist in der Fig. 10b als Schnittpunkt der gestrichelten Linie mit der U-Achse dargestellt. Diese effektive Spannung ist etwas weniger negativ als die Spannung am Gitter 38, so daß sich ein positives Spannungsgefälle ergibt, das die Elektronen und negativen Ionen anzieht. Zwischen den Gittern 38 und 39 besteht ein sehr starkes positives Spannungsgefälle, durch welches die Elektronen und negativen Ionen beschleunigt werden. Anschließend werden die negativen Teilchen durch ein negatives Spannungsgefälle zwischen den Gittern 39 und 40 wieder etwas abgebremst.

Ein Potentialverlauf über die Strecke zwischen der Plasmakammer und Probentisch 7, mit dem neutrale Teilchen aus der Plasmakammer abgezogen werden können, ist in der Fig. 10c gezeigt. Der negative Spannungsabfall zwischen dem Gitter 38 und dem Ausgang der Kammer zieht zunächst positive Teilchen aus der Kammer und sperrt negative Teilchen. Neutrale Teilchen gelangen aufgrund ihrer Bewegungsenergie ungehindert durch alle Potentialschwellen, die durch die Gitter 38, 39, 40 aufgebaut werden. Die zwischen den Gittern 38, 39 befindlichen positiven Teilchen werden durch das negative Spannungsgefälle weiter beschleunigt, gleichzeitig werden negative Teilchen, welche die Potentialschwelle am Gitter 38 überwunden hatten, durch den positiven Spannungsabfall in Richtung auf die Kammer beschleunigt und damit vom Probentisch 7 ferngehalten. Zwischen den Gittern 39 und 40 herrscht ein starker positiver Spannungsabfall, der die positiven Teilchen abbremst und vom Probentisch 7 fernhält. Somit gelangen nur neutrale Teilchen auf den Probentisch.

Die in Verbindung mit einem Koaxialkabel vorgesehenen zusätzlichen Elektromagnete 66, 67 können analog auch bei einer Anordnung gemäß den Fig. 1 bis 4 vorgesehen sein, wobei ihre toroidförmigen Felder sowohl vertikal als auch horizontal in den Behälter 26 hineinragen können.

**Patentansprüche**

1. Teilchenquelle, insbesondere für eine reaktive Ionenstrahlätz- oder Plasmadepositionsanlage, mit

1.1 einem Behälter (26) aus einem nicht ferromagnetischen und nichtleitenden Material für ein Gas oder Gasgemisch oder Plasma, der einen oberen Abschluß (27) und eine diesem oberen Abschluß (27) gegenüberliegende Öffnung besitzt, aus der gasförmige Teilchen aus dem Behälter (26) austreten können;

1.1.1 wobei dieser Behälter (26) auch einen seitlichen Abschluß (28) aufweist, der von einem elektrisch leitenden, aber nicht ferromagnetischen Hohlkörper (90) umgeben ist;

1.2 einer Zuführung (55) für ein Gas oder ein Gasgemisch in den Behälter (26);

1.3 einer Vorrichtung (29) für die Zuführung elektromagnetischer Wellen, vorzugsweise von Mikrowellen, die an den oberen Abschluß (27) des Behälters (26) anschließt und

1.3.1 die als Trichterstrahler ausgeführt ist, dessen weiteste Trichteröffnung im wesentlichen der Fläche des oberen Abschlusses (27) des Behälters (26) entspricht;

1.4 einem Magnetfelderzeuger (32, 33), der auf der Außenseite des Hohlkörpers (90) angeordnet ist und der wenigstens einen Nord- und einen Südpol enthält, wobei Nord- und Südpol derart auf den Behälter (26) gerichtet sind, daß sich ein gekrümmtes Magnetfeld zwischen Nord- und Südpol ausbildet, das in das Innere des Behälters (26) hineinragt, wobei

1.4.1 der Magnetfelderzeuger (32, 33) sich in der Höhe im wesentlichen von der Öffnung des Behälters (26) bis zur weitesten Trichteröffnung des Trichterstrahlers (29) erstreckt und wobei

1.4.2 der Magnetfelderzeuger (32, 33) sich um den ganzen Behälter (26) herum erstreckt, so daß das gekrümmte Magnetfeld zwischen Nord- und Südpol ein im wesentlichen toroidförmiges Feld bildet, das aus dem seitlichen Abschluß (28) in den Behälter (26) eintritt und vom Behälter (26) in den seitlichen Abschluß (28) wieder austritt.

2. Teilchenquelle, insbesondere für eine reaktive Ionenstrahlätz- oder Plasmadepositionsanlage, mit

2.1 einem Behälter aus elektrisch nichtleitendem Material, der ein für die Plasmaanregung vorgesehenes Gas oder Gasgemisch umschließt und der einen oberen Abschluß und Seitenwände sowie eine Öffnung zum Extrahieren geladener und/oder ungeladener Teilchen besitzt,

2.2 einer Zuführung für elektromagnetische Wellen, vorzugsweise von Mikrowellen, welche dem Gas oder Gasgemisch Mikrowellenenergie zuführt,

2.3 einem ersten Magnetfelderzeuger (32, 33), der die Seitenwände des Behälters (26) vollständig umschließt und wenigstens einen Nordpol und einen Südpol enthält, wobei Nord- und Südpol über den ganzen Umfang des Behälters (26) nebeneinander angeordnet und so auf den Behälter (26) gerichtet sind, daß sich ein im wesentlichen toroidförmiges Magnetfeld vom Nord- zum Südpol ausbildet, das in das Innere des Behälters (26) hineinragt und beim Eintritt in den Behälter (26) im wesentlichen auf der Behälter-Innenwand senkrecht steht;

2.4 einem zweiten Magnetfelderzeuger (65) mit wenigstens einem Nord- und einem Südpol, der zentrisch zum ersten Magnetfelderzeuger (32, 33) in einer in das Behälterinnere hineinragenden Einbuchtung (68) des oberen Abschlusses (27) des Behälters (26) derart angeordnet ist, daß die vom Inneren des Behälters (26) abgewandte Oberkante des zweiten Magnetfelderzeugers (65) im wesentlichen mit der Oberkante des ersten Magnetfelderzeugers (32, 33) fluchtet, wobei die sich vom Nord- zum Südpol erstreckenden magnetischen Feldlinien wenigstens teilweise im Inneren des Behälters (26) verlaufen und ein rotationssymmetrisches, toroidförmiges Feld bilden.

3. Teilchenquelle nach Anspruch 1, **dadurch gekennzeichnet**, daß die vom Hohlkörper (90) abgewandten Pole des Magnetfelderzeugers (32, 33) durch ein ferromagnetisches Joch (34) miteinander verbunden sind.

4. Teilchenquelle nach Anspruch 1, **dadurch gekennzeichnet**, daß der Trichterstrahler (29) ein Kegelhornstrahler ist.

5. Teilchenquelle nach Anspruch 1, **dadurch gekennzeichnet**, daß der Trichterstrahler ein Pyramidenhornstrahler ist.

6. Teilchenquelle nach Anspruch 1, **dadurch gekennzeichnet**, daß zur potentialmäßigen Trennung zwischen dem Trichterstrahler (29) und dem Hohlkörper (90) eine Isolationsschicht vorgesehen ist.

7. Teilchenquelle nach Anspruch 1, **dadurch gekennzeichnet**, daß die Stärke des Magnetfelds des Magnetfelderzeugers derart ist, daß eine Elektronen-Zyklotron-Resonanz entsteht.

8. Teilchenquelle nach Anspruch 1, **dadurch gekennzeichnet**, daß der Magnetfelderzeuger wenigstens zwei Dauermagnete (32, 33) enthält, die übereinander angeordnet sind und den Umfang des Behälters (26) umschließen, wobei der auf den Behälter (26) gerichtete Pol des einen Dauermagneten (32) ein Nordpol ist, während der auf den Behälter (26) gerichtete Pol des anderen Dauermagneten (33) ein Südpol ist und wobei die magnetischen Feldlinien der beiden Dauermagnete (32, 33) eine Elektronenbeschleunigung bewirken.

9. Teilchenquelle nach Anspruch 1, **dadurch gekennzeichnet**, daß der Behälter (26) zusätzlich von einem nach Art einer Zylinderspule ( = Solenoid) ausgebildeten Elektromagneten (36) umgeben ist.

10. Teilchenquelle nach Anspruch 1, **dadurch gekennzeichnet**, daß an der Öffnung des Behälters (26) wenigstens eine Vorrichtung (4) für die gesteuerte Extraktion von in dem Behälter (26) befindlichen Partikeln vorgesehen ist.

11. Teilchenquelle nach Anspruch 1, **dadurch gekennzeichnet**, daß der Trichterstrahler (29) mit dem elektrisch leitenden Hohlkörper (90) aus nicht ferromagnetischem Material elektrisch leitend verbunden ist und daß dieser Hohlkörper (90) elektrisch isoliert an einen kühlbaren Träger (41) anschließt.

12. Teilchenquelle nach Anspruch 10, **dadurch gekennzeichnet**, daß die Vorrichtung (4) für die gesteuerte Extraktion von in dem Behälter (26) befindlichen Partikeln drei Steuergitter (38, 39, 40) aufweist, die auf kühlbaren Trägern (41, 42, 43) angeordnet sind, wobei diese Träger (41, 42, 43) als Hohlkörper ausgebildet sind, durch die ein Kühlmittel strömt.

13. Teilchenquelle nach Anspruch 12, **dadurch gekennzeichnet**, daß wenigstens ein Träger (41) einen Gaseinlaß (55) aufweist, durch den Gas in den Behälter (26) strömt.

14. Teilchenquelle nach Anspruch 1, **dadurch gekennzeichnet**, daß der Magnetfelderzeuger ein Hufeisenmagnet ist, dessen Nord- und Südpol auf den Innenraum des Behälters (26) gerichtet sind.

15. Teilchenquelle nach Anspruch 1, **dadurch gekennzeichnet**, daß an der Öffnung des Behälters (26) drei hintereinander angeordnete Steuergitter (38, 39, 40) vorgesehen sind und daß für die Erzeugung der wirksamen Beschleunigungsspannung zum Extrahieren positiver Ionen das dem Plasma am nächsten liegende Gitter (38) auf positives Potential, das mittlere Gitter (39) auf negatives Potential und das vom Plasma am weitesten entfernte Gitter (40) auf Nullpotential gelegt ist.

16. Teilchenquelle nach Anspruch 1, **dadurch gekennzeichnet**, daß an der Öffnung des Behälters (26) drei hintereinander angeordnete Steuergitter (38, 39, 40) vorgesehen sind und daß für die Erzeugung der wirksamen Beschleunigungsspannung zum Extrahieren von Elektronen und negativen Ionen das dem Plasma am nächsten liegende Gitter (38) auf negatives Potential, das mittlere Gitter (39) auf positives Potential und das vom Plasma am weitesten entfernte Gitter (40) auf Nullpotential gelegt ist.

17. Teilchenquelle nach Anspruch 1, **dadurch gekennzeichnet**, daß an der Öffnung des Behälters (26) drei hintereinander angeordnete Steuergitter (38, 39, 40) vorgesehen sind und daß für die Erzeugung der wirksamen Beschleunigungsspannung zum Extrahieren von neutralen Teilchen das dem Plasma am nächsten liegende Gitter (38) auf positives Potential, das mittlere Gitter (39) auf negatives Potential und das vom Plasma am weitesten entfernte Gitter (40) auf positives Potential gelegt ist.

18. Teilchenquelle nach Anspruch 1, **dadurch gekennzeichnet**, daß an der Öffnung des Behälters (26) wenigstens eine magnetische Extraktionseinheit (60) vorgesehen ist.

19. Teilchenquelle nach Anspruch 1, **dadurch gekennzeichnet**, daß der Druckbereich im Behälter (26) zwischen 0,1 Pa und einigen $10^3$ Pa ( = zwischen $10^{-3}$ mbar und einigen 10 mbar) liegt.

**Claims**

1. Particle source, in particular for a reactive ion beam etching or plasma deposition system, having

   1.1 a container (26) of a non-ferromagnetic and non-conductive material for a gas or gas mixture or plasma, having an upper closure (27) and an opening which is opposite this upper closure (27) and from which gaseous particles can emerge from the container (26);

      1.1.1 this container (26) also having a lateral closure (28) which is surrounded by an electrically conductive but non-ferromagnetic hollow body (90);

1.2 a supply line (55) into the container (26) for a gas or a gas mixture;

1.3 an apparatus (29) for supplying electromagnetic waves, preferably microwaves, which adjoins the upper closure (27) of the container (26) and

    1.3.1 which is constructed as a funnel-type radiation means whereof the widest funnel opening substantially corresponds to the surface of the upper closure (27) of the container (26);

1.4 a magnetic field generator (32, 33) which is arranged on the outside of the hollow body (90) and which contains at least one north and one south pole, north and south pole being directed towards the container (26) such that there is formed between north and south pole a curved magnetic field which projects into the interior of the container (26),

    1.4.1 the magnetic field generator (32, 33) extending in height substantially from the opening of the container (26) as far as the widest funnel opening of the funnel-type radiation means (29), and

    1.4.2 the magnetic field generator (32, 33) extending around the entire container (26) so that the curved magnetic field between north and south pole forms a substantially toroidal field which enters the container (26) from the lateral closure (28) and emerges from the container (26) again into the lateral closure (28).

2. Particle source, in particular for a reactive ion beam etching or plasma deposition system, having

    2.1 a container of electrically non-conductive material which surrounds a gas or gas mixture provided for the plasma excitation and which has an upper closure and side walls and an opening for the extraction of charged and/or uncharged particles,

    2.2 a supply for electromagnetic waves, preferably microwaves, which supplies microwave energy to the gas or gas mixture,

    2.3 a first magnetic field generator (32, 33) which completely surrounds the side walls of the container (26) and which contains at least one north pole and one south pole, north and south pole being arranged next to one another over the entire periphery of the container (26) and being directed towards the container (26) such that a substantially toroidal magnetic field is formed from the north to the south pole which projects into the interior of the container (26) and which is substantially perpendicular on the container inner wall on entry into the container (26);

    2.4 a second magnetic field generator (65) which has at least one north and one south pole, which is arranged centrally with respect to the first magnetic field generator (32, 33) in a hollow (68), projecting into the container interior, in the upper closure (27) of the container (26) such that the upper edge of the second magnetic field generator (65) remote from the interior of the container (26) is substantially flush with the upper edge of the first magnetic field generator (32, 33), the magnetic field lines extending from the north to the south pole running at least partially in the interior of the container (26) and forming a rotationally symmetrical toroidal field.

3. Particle source according to Claim 1, characterized in that the poles of the magnetic field generator (32, 33) remote from the hollow body (90) are connected to one another by a ferromagnetic yoke (34).

4. Particle source according to Claim 1, characterized in that the funnel-type radiation means (29) is a conical horn radiation means.

5. Particle source according to Claim 1, characterized in that the funnel-type radiation means is a pyramid-shaped horn radiation means.

6. Particle source according to Claim 1, characterized in that an insulation layer is provided for the separation of potential between the funnel-type radiation means (29) and the hollow body (90).

7. Particle source according to Claim 1, characterized in that the strength of the magnetic field of the magnetic field generator is such that a microtron resonance is produced.

8. Particle source according to Claim 1, characterized in that the magnetic field generator contains at least two permanent magnets (32, 33) which are arranged one above the other and surround the periphery of the container (26), the pole of the one permanent magnet (32) directed towards the container (26) being a north pole, whereas the pole of the other permanent magnet (33) directed towards the container (26) is a south pole, and the magnetic field lines of the two permanent magnets (32, 33) effecting an electron acceleration.

9. Particle source according to Claim 1, characterized in that the container (26) is additionally surrounded by an electromagnet (36) constructed in the manner of a cylindrical coil (= solenoid).

10. Particle source according to Claim 1, characterized in that at least one apparatus (4) for the controlled extraction of particles in the container (26) is provided at the opening of the container (26).

11. Particle source according to Claim 1, characterized in that the funnel-type radiation means (29) is connected in electrically conductive manner to the electrically conductive hollow body (90) of non-ferromagnetic material, and in that this hollow body (90) adjoins in electrically insulated manner a support (41) which can be cooled.

12. Particle source according to Claim 10, characterized in that the apparatus (4) for the controlled extraction of particles in the container (26) has three control grids (38, 39, 40) which are arranged on supports (41, 42, 43) which may be cooled, these supports (41, 42, 43) being constructed as hollow bodies through which a coolant flows.

13. Particle source according to Claim 12, characterized in that at least one support (41) has a gas inlet (55) through which gas flows into the container (26).

14. Particle source according to Claim 1, characterized in that the magnetic field generator is a horseshoe magnet whereof the north and south pole are directed towards the interior of the container (26).

15. Particle source according to Claim 1, characterized in that three control grids (38, 39, 40) arranged one behind the other are provided at the opening of the container (26), and in that for the generation of the active acceleration voltage for the extraction of positive ions positive potential is applied to the grid (38) closest to the plasma, negative potential is applied to the central grid (39) and zero potential is applied to the grid (40) furthest away from the plasma.

16. Particle source according to Claim 1, characterized in that three control grids (38, 39, 40) arranged one behind the other are provided at the opening of the container (26), and in that for the generation of the active acceleration voltage for the extraction of electrons and negative ions negative potential is applied to the grid (38) closest to the plasma, positive potential is applied to the central grid (39) and zero potential is applied to the grid (40) furthest away from the plasma.

17. Particle source according to Claim 1, characterized in that three control grids (38, 39, 40) arranged one behind the other are provided at the opening of the container (26), and in that for the generation of the active acceleration voltage for the extraction of neutral particles positive potential is applied to the grid (38) closest to the plasma, negative potential is applied to the central grid (39) and positive potential is applied to the grid (40) furthest away from the plasma.

18. Particle source according to Claim 1, characterized in that at least one magnetic extraction unit (60) is provided at the opening of the container (26).

19. Particle source according to Claim 1, characterized in that the pressure range in the container (26) is between 0.1 Pa and a few $10^3$ Pa (= between $10^{-3}$ mbar and a few 10 mbar).

**Revendications**

1. Source de particules, en particulier pour un dispositif réactif d'attaque par rayonnement d'ions ou de déposition de plasma, comportant
   1.1 un récipient (26) en un matériau non ferromagnétique et non conducteur, pour un gaz ou un mélange de gaz ou un plasma, comportant une bordure supérieure (27) et une ouverture placée en regard de cette bordure supérieure (27), d'où des particules gazeuses peuvent sortir du récipient (26);
      1.1.1 ce récipient (26) présentant également une bordure latérale (28) entourée par un corps creux (90) conducteur de l'électricité mais non ferromagnétique;
   1.2 une amenée (55) pour un gaz ou un mélange de gaz dans le récipient (26);
   1.3 un dispositif (29) pour l'amenée d'ondes électromagnétiques, de préférence de micro-ondes, raccordé à la bordure supérieure (27) du récipient (26), et
      1.3.1 le dispositif étant réalisé sous forme d'émetteur de rayonnements, dont la plus grande ouverture d'entonnoir correspond pratiquement à l'aire de la bordure (27) supérieure du récipient (26);

1.4 un générateur de champ magnétique (32, 33), disposé sur la face extérieure du corps creux (90) et contenant au moins un pôle nord et un pôle sud, le pôle nord et le pôle sud étant orientés sur le récipient (26), de manière que s'établisse un champ magnétique courbe entre le pôle nord et le pôle sud, champ magnétique pénétrant à l'intérieur du récipient (26),

1.4.1 le générateur de champ magnétique (32, 33) s'étendant pratiquement à la hauteur de l'ouverture du récipient (26) jusqu'à la plus grande ouverture d'entonnoir de l'émetteur de rayonnements (29) en forme d'entonnoir, et

1.4.2 le générateur de champ magnétique (32, 33) s'étendant tout autour de l'ensemble du récipient (26), de sorte que le champ magnétique courbe forme entre le pôle nord et le pôle sud un champ sensiblement toroïdal, pénétrant, depuis la bordure latérale (28), dans le récipient (26), et ressortant du récipient (26) pour aller dans la bordure latérale (28).

2. Source de particules en particulier pour un dispositif réactif d'attaque par rayonnement d'ions ou de déposition de plasma, comportant :

2.1 un récipient en matériau non conducteur de l'électricité, renfermant un gaz ou un mélange de gaz prévu pour l'excitation du plasma et comportant une bordure supérieure et des parois latérales ainsi qu'une ouverture pour extraire des particules chargées et/ou non chargées,

2.2 une conduite pour ondes électromagnétiques, de préférence pour micro-ondes, amenant de l'énergie des micro-ondes au gaz ou au mélange de gaz

2.3 un premier générateur de champ magnétique (32, 33), entourant complètement les parois latérales du récipient (26) et contenant au moins un pôle nord et un pôle sud, le pôle nord et le pôle sud étant disposés l'une à côté de l'autre sur la totalité de la périphérie du récipient (26) et orientés en direction du récipient (26), de manière que s'établisse un champ magnétique sensiblement toroïdal, allant du pôle nord au pôle sud, champ pénétrant à l'intérieur du récipient (26) et étant orienté pratiquement perpendiculairement par rapport à la paroi intérieure du récipient lors de l'entrée dans le récipient (26);

2.4 un deuxième générateur de champ magnétique (65), avec au moins un pôle nord et un pôle sud, disposés centralement par rapport au premier générateur de champ magnétique (32, 33) dans un renfoncement (68), de la bordure supérieure (27) du récipient (26) pénétrant à l'intérieur du récipient, de manière que l'arête supérieure du deuxième générateur de champ magnétique (65) orientée en direction opposée par rapport à l'intérieur du récipient (26) soit sensiblement alignée avec l'arête supérieure du premier générateur de champ magnétique (32, 33), les lignes de champ magnétique, allant du pôle nord au pôle sud, s'étendant partiellement à l'intérieur du récipient (26) et formant un champ toroïdal répondant à une symétrie de rotation.

3. Source de particules selon la revendication 1, caractérisée en ce que les pôles de générateur de champ magnétique (32, 33), situés à l'opposé du corps creux (90), sont reliés par une culasse (34) ferromagnétique.

4. Source de particules selon la revendication 1, caractérisée en ce que l'émetteur de rayonnement en forme d'entonnoir (29) est un émetteur de rayonnement à cornet conique.

5. Source de particules selon la revendication 1, caractérisée en ce que l'émetteur de rayonnement en forme d'entonnoir est un émetteur à cornet pyramidal.

6. Source de particules selon la revendication 1, caractérisée en ce qu'une couche d'isolation est prévue entre l'émetteur de rayonnement en forme d'entonnoir (29) et le corps creux (90) en vue d'assurer une séparation de potentiel.

7. Source de particules selon la revendication 1, caractérisée en ce que l'intensité du champ magnétique du générateur est telle qu'est produite une résonance de type électrons-cyclotron.

8. Source de particules selon la revendication 1, caractérisée en ce que le générateur de champ magnétique contient au moins deux aimants permanents (32, 33) disposés l'un au dessus de l'autre et entourant la périphérie du récipient (26), le pôle d'un premier aimant permanent (32), orienté en direction du récipient (26), étant un pôle nord, tandis que le pôle de l'autre aimant permanent (33), orienté en direction du récipient (26), est un pôle sud et les lignes de champ magnétique des deux aimants permanents (32, 33) provoquant une accélération des électrons.

9. Source de particules selon la revendication 1, caractérisée en ce que le récipient (26) est, de plus, entouré par un électroaimant (36) réalisé à la façon d'une bobine cylindrique (= solénoïde).

10. Source de particules selon la revendication 1, caractérisée en ce qu'au moins un dispositif (4) destiné à assurer l'extraction commandée de particules se trouvant dans le récipient (26), est prévu au niveau de l'ouverture du récipient (26).

11. Source de particules selon la revendication 1, caractérisée en ce que l'émetteur de rayonnement en forme d'entonnoir (29) est relié, de façon à pouvoir conduire l'électricité, au corps creux (90) non-conducteur de l'électricité et réalisé en un matériau non ferromagnétique, et en ce que ce corps creux (90) est raccordé, de façon isolée électriquement, à un support (41) pouvant être refroidi.

12. Source de particules selon la revendication 10, caractérisée en ce que le dispositif (4) destiné à assurer l'extraction commandée de particules se trouvant dans le récipient (26) présente trois grilles de commande (38, 39, 40), disposées sur les supports (41, 42, 43) pouvant être refroidis, ces supports (41, 42, 43) étant réalisés sous forme de corps creux à travers lesquels s'écoule un produit de refroidissement.

13. Source de particules selon la revendication 12, caractérisée en ce qu'au moins un support (41) présente une entrée de gaz (55), au travers de laquelle le gaz s'écoute dans le récipient (26).

14. Source de particules selon la revendication 1, caractérisée en ce que le générateur de champ magnétique est un aimant en fer à cheval, dont le pôle nord et le pôle sud sont orientés en direction de l'espace intérieur du récipient (26).

15. Source de particules selon la revendication 1, caractérisée en ce qu'au niveau de l'ouverture du récipient (26) sont prévues trois grilles de commande (38, 39, 40) disposées les unes derrière les autres, et en ce que pour produire la tension efficace d'accélération en vue d'extraire des ions positifs, la grille (38) située la plus près du plasma est placée à un potentiel positif, la grille médiane (39) à un potentiel négatif et la grille (40) la plus éloignée du plasma est placée au potentiel zéro.

16. Source de particules selon la revendication 1, caractérisée en ce que trois grilles de commandes (38, 39, 40) disposées les unes derrière les autres sont prévues au niveau de l'ouverture du récipient (26), et en ce que, pour la production de la tension efficace d'accélération en vue de l'extraction d'électrons et d'ions négatifs, la grille (38) située la plus près du plasma est placée à un potentiel négatif, la grille médiane (39) à un potentiel positif et la grille (40) la plus éloignée du plasma au potentiel zéro.

17. Source de particules selon la revendication 1, caractérisée en ce que trois grilles de commande (38, 39, 40) disposées les unes derrière les autres au niveau de l'ouverture du récipient (26) sont prévues, et en ce que, pour la production de la tension efficace d'accélération destinée à l'extraction de particules neutres, la grille (38) située la plus près du plasma est placée à un potentiel positif, la grille médiane (39) à un potentiel négatif et la grille (40) la plus éloignée du plasma à un potentiel positif.

18. Source de particules selon la revendication 1, caractérisée en ce qu'au moins une unité d'extraction (60) magnétique est prévue au niveau de l'ouverture du récipient (26).

19. Source de particules selon la revendication 1, caractérisée en ce que la plage de pression dans le récipient (26) est située entre 0,1 Pa et quelques $10^3$ Pa (= entre $10^{-3}$ mbar et quelques 10 mbar).

# FIG.1

# FIG. 2

# FIG.3

# FIG. 4

## FIG.5

FIG.6

FIG. 7a

FIG. 7b

FIG. 7c

FIG. 7d

# FIG.8

# FIG.9

FIG. 10

FIG. 10 a

FIG. 10 b

FIG. 10 c